# EUROPEAN PATENT APPLICATION

(11) **EP 4 694 616 A1**
(43) Date of publication of application: **11.02.2026**
(21) Application number: 25184657.2
(22) Date of filing: 23.06.2025
(51) Int. Cl.: H10D 30/01, H10D 30/67

(54) **DISPLAY PANEL AND DISPLAY DEVICE**

(30) Priority: 09.08.2024 CN 202411089051
(71) Applicant: TCL China Star Optoelectronics Technology Co., Ltd., Shenzhen, Guangdong 518132 (CN)
(72) Inventor: ZHENG, Shuai, Shenzhen, 518132 (CN)
(74) Representative: Murgitroyd & Company

(57) **Abstract**

The disclosure provides a display panel and a display device. The display panel includes an active layer, a first gate insulating layer, a first gate, and a second gate insulating layer; the first gate insulating layer covers the active layer; the first gate is disposed on a side of the first gate insulating layer away from the active layer; the second gate insulating layer is disposed on a side of the first gate insulating layer away from the active layer and covers the first gate, and the second gate insulating layer contains hydrogen element; and the first gate insulating layer includes a first sub-portion disposed between the active layer and the first gate, and a second sub-portion connected to the first sub-portion, and a thickness of the first sub-portion is greater than a thickness of the second sub-portion.

## Description

### TECHNICAL FIELD

The disclosure relates to the field of display, and in particular, to a display panel and a display device.

### BACKGROUND

Thin film transistors of a display panel need to undergo hydrogenation treatment during the production process. Taking a structure of low-temperature polycrystalline silicon (LTPS) thin film transistors in the display panel as an example, the LTPS thin film transistors undergo hydrogenation treatment during the production process, which improves electron mobility of the LTPS thin film transistors, repair defects of the LTPS thin film transistors, and enables the LTPS thin film transistors to have higher carrier mobility.

At present, two gates are generally provided above an active layer in the display panel, and a gate insulating layer between the two gates is made of silicon nitride. Hydrogen in the gate insulating layer is often supplied to the active layer by a baking process. However, the ability of the display panel to supply hydrogen for the active layer is insufficient, causing the thin film transistors in the display panel to have large sub-threshold swing and lower mobility, affecting electrical properties of the thin film transistors, and affecting the stability and display effect of the display panel.

### SUMMARY

Embodiments of the disclosure provide a display panel and a display device, which can enhance the ability of the display panel to supply hydrogen for an active layer, and improve the stability and display effect of the display panel.

Some embodiments of the disclosure provide a display panel, including:
an active layer;
a first gate insulating layer covering the active layer;
a first gate disposed on a side of the first gate insulating layer away from the active layer; and
a second gate insulating layer disposed on a side of the first gate insulating layer away from the active layer and covering the first gate, in which the second gate insulating layer contains hydrogen element;
in which the first gate insulating layer includes a first sub-portion disposed between the active layer and the first gate, and a second sub-portion connected to the first sub-portion, and a thickness of the first sub-portion is greater than a thickness of the second sub-portion.

Some embodiments of the disclosure further provide a display device including the above-mentioned display panel.

In the embodiments of the disclosure, by setting the first gate insulating layer having different thicknesses, specifically, by setting the thickness of the first sub-portion corresponding to the first gate greater than the thickness of the second sub-portion not corresponding to the first gate, on the basis of ensuring the insulation between the first gate and the active layer, it can be achieved that hydrogen in the second gate insulating layer can more easily diffuse into the active layer through the second sub-portion, which enhances the ability of the display panel to supply hydrogen for the active layer, and improves the stability and display effect of the display panel.

### BRIEF DESCRIPTION OF THE DRAWINGS

In order to explain technical solutions in embodiments of the disclosure more clearly, the following will briefly introduce the drawings needed to be used in description of the embodiments. Apparently, the drawings in the following description are only some embodiments of the disclosure. For ordinary skilled in the art, other drawings can be obtained from these drawings without paying creative effort.
FIG. 1 is a first schematic structural diagram of a display panel provided by some embodiments of the disclosure.
FIG. 2 is a second schematic structural diagram of a display panel provided by some embodiments of the disclosure.
FIG. 3 is a third schematic structural diagram of a display panel provided by some embodiments of the disclosure.
FIG. 4 is a fourth schematic structural diagram of a display panel provided by some embodiments of the disclosure.

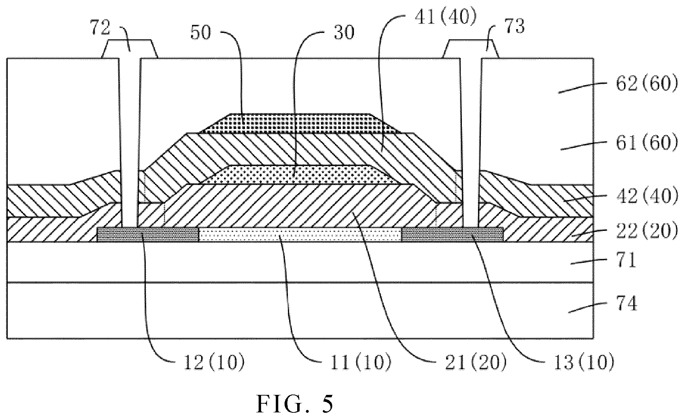

FIG. 5 is a fifth schematic structural diagram of a display panel provided by some embodiments of the disclosure.

### DETAILED DESCRIPTION

The following will provide a clear and complete description of technical solutions in embodiments of the disclosure in conjunction with the drawings. Apparently, the following embodiments are only a part of the embodiments of the disclosure, not all of them. Based on the embodiments of the disclosure, all other embodiments obtained by those skilled in the art without creative labor are within the scope of protection of the disclosure.

The following description provides many different embodiments or examples to describe different structures of the disclosure. In order to simplify the disclosure, specific embodiments of components and settings are described in the context. Of course, they are only examples and are not intended to limit the scope of the disclosure. In addition, the disclosure may repeat reference numbers and/or reference letters in different embodiments for the purpose of simplification and clarity, and does not in itself indicate the relationship between the various embodiments and/or settings discussed. Moreover, the disclosure provides examples of various specific processes and materials, but those of ordinary skill in the art may be aware of the use of other processes and/or the use of other materials.

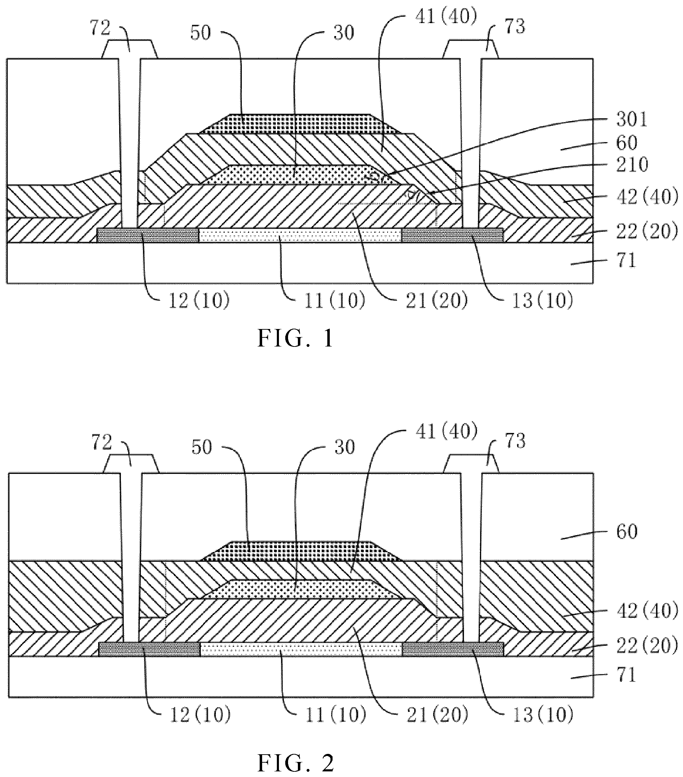

As illustrated in FIG. 1, some embodiments of the disclosure provide a display panel including an active layer 10, a first gate insulating layer 20, a first gate 30, and a second gate insulating layer 40.

The first gate insulating layer 20 covers the active layer 10. The first gate 30 is disposed on a side of the first gate insulating layer 20 away from the active layer 10. The second gate insulating layer 40 is disposed on a side of the first gate insulating layer 20 away from the active layer 10 and covers the first gate 30. The second gate insulating layer 40 contains hydrogen element.

In some embodiments, the first gate insulating layer 20 includes a first sub-portion 21 disposed between the active layer 10 and the first gate 30, and a second sub-portion 22 connected to the first sub-portion 21. A thickness of the first sub-portion 21 is greater than a thickness of the second sub-portion 22.

In the embodiments of the disclosure, by setting the first gate insulating layer 20 having different thicknesses, specifically, by setting the thickness of the first sub-portion 21 corresponding to the first gate 30 greater than the thickness of the second sub-portion 22 not corresponding to the first gate 30, on the basis of ensuring the insulation between the first gate 30 and the active layer 10, it can be achieved that hydrogen in the second gate insulating layer 40 can more easily diffuse into the active layer 10 through the second sub-portion 22, which enhances the ability of the display panel to supply hydrogen for the active layer 10, and improves the stability and display effect of the display panel.

Specifically, please continue to refer to FIG. 1. In some embodiments, the display panel further includes a buffer layer 71, and the active layer 10 is disposed on the buffer layer 71.

In some embodiments, the buffer layer 71 includes a silicon nitride layer and a silicon oxide layer disposed in stack.

The first gate insulating layer 20 is disposed on the buffer layer 71 and covers the active layer 10. The first gate 30 is disposed on a side of the first gate insulating layer 20 away from the active layer 10. The second gate insulating layer 40 is disposed on a side of the first gate insulating layer 20 away from the active layer 10 and covers the first gate 30.

In some embodiments, a material of the first gate insulating layer 20 includes silicon oxide. A material of the second gate insulating layer 40 includes at least one of silicon nitride and silicon oxynitride, or other materials that can be used for supplying hydrogen, which is not limited herein.

In some embodiments, the display panel further includes a second gate 50, an interlayer dielectric layer 60, a source 72, and a drain 73. The second gate 50 is disposed on a side of the second gate insulating layer 40 away from the first gate insulating layer 20. The interlayer dielectric layer 60 is disposed on the second gate insulating layer 40 and covers the second gate 50. The source 72 and the drain 73 are disposed on the interlayer dielectric layer 60. The source 72 passes through the interlayer dielectric layer 60, the second gate insulating layer 40, and the first gate insulating layer 20, and is connected to a first doping portion 12 of the active layer 10. The drain 73 passes through the interlayer dielectric layer 60, the second gate insulating layer 40, and the first gate insulating layer 20, and is connected to a second doping portion 13 of the active layer 10.

It can be understood that the active layer 10, the first gate 30, the second gate 50, the source 72, and the drain 73 constitute a thin film transistor of the display panel, and the display panel further includes a driving circuit, which includes the thin film transistor that can control turn-on and turn-off of signals in the driving circuit.

In some embodiments, the active layer 10 includes a channel portion 11, the first doping portion 12, and the second doping portion 13. The first doping portion 12 and the second doping portion 13 are connected to opposite two sides of the channel portion 11, respectively. The first gate 30 is disposed on a side of the first gate insulating layer 20 away from the channel portion 11. The first gate 30 is in para-position with the channel portion 11 in a thickness direction of the display panel.

In some embodiments, the first gate insulating layer 20 includes the first sub-portion 21 disposed between the first gate 30 and the active layer 10, and the second sub-portion 22 connected to the first sub-portion 21. Furthermore, the first sub-portion 21 is disposed between the first gate 30 and the channel portion 11, and the second sub-portion 22 covers an area outside the channel portion 11.

In some embodiments, an orthographic projection of the first gate 30 on the second gate insulating layer 40 is located within an orthographic projection of the first sub-portion 21 on the second gate insulating layer 40, and the orthographic projection of the first gate 30 on the second gate insulating layer 40 does not overlap with an orthographic projection of the second sub-portion 22 on the second gate insulating layer 40.

By setting the thickness of the first sub-portion 21 greater than the thickness of the second sub-portion 22, the embodiments enables a distance between the second gate insulating layer 40 and the active layer 10 at the second sub-portion 22 to be less than a distance between the second gate insulating layer 40 and the active layer 10 at the first sub-portion 21. Therefore, during the baking process for preparing the display panel, hydrogen in the second gate insulating layer 40 can more easily diffuse into the active layer 10, effectively improving the ability of the display panel to supply hydrogen for the active layer 10.

During the process for preparing the display panel, after forming the first gate 30, the first gate 30 can be used as a mask to etch a part of the first gate insulating layer 20 not covered by the first gate 30, so as to reduce a thickness of the part of the first gate insulating layer 20 not covered by the first gate 30, and thus form the first sub-portion 21 and the second sub-portion 22 with different thicknesses. For example, the second gate insulating layer 40 is treated a dry etching process under the atmosphere of CF₄ and O₂.

**In** some embodiments, a material of the active layer 10 includes low-temperature polycrystalline silicon (a-Si), and the first doping portion 12 and the second doping portion 13 can be conductive portions formed by doping boron (B) with a-Si. As discussed above, since the embodiments of the disclosure improve the ability to supply hydrogen for the active layer 10, dangling bonds of a-Si in the active layer 10 can combine with hydrogen to form stable Si-H bonds, effectively reducing the sub-threshold swing of the thin film transistor, improving the mobility of the thin film transistor, and enhancing the performance of the thin film transistor.

In some embodiments, the orthographic projection of the second sub-portion 22 on the second gate insulating layer 40 overlaps with an orthographic projection of the first doping portion 12 on the second gate insulating layer 40, and the orthographic projection of the second sub-portion 22 on the second gate insulating layer 40 overlaps with an orthographic projection of the second doping portion 13 on the second gate insulating layer 40; and the orthographic projection of the second sub-portion 22 on the second gate insulating layer 40 does not overlap with an orthographic projection of the channel portion 11 on the second gate insulating layer 40.

Since the second sub-portion 22 is disposed on the first doping portion 12 and the second doping portion 13, the embodiments of the disclosure can reduce the dosage of boron for doping the first doping portion 12 and the second doping portion 13 and the energy required for the doping process. For example, the dosage of dopants and energy required for the doping can be reduced during an ion bombardment process.

In some embodiments, the thickness of the second sub-portion 22 is greater than or equal to 50 nm and less than 130 nm, for example, 50 nm, 60 nm, 70 nm, 80 nm, 90 nm, 100 nm, 110 nm, or 120 nm; and the thickness of the first sub-portion 21 is greater than or equal to 130 nm.

In some embodiments, a difference between the thickness of the first sub-portion 21 and the thickness of the second sub-portion 22 is less than or equal to 80 nm, so as to avoid a too large step difference at the surface of the first gate insulating layer 20 caused by different thicknesses of the first gate insulating layer 20, reduce the fracture risk of subsequent film layers due to the step difference being too large, and improve yield of the display panel.

In some embodiments, a thickness of an end of the first sub-portion 21 gradually decreases in a direction close to the second sub-portion 22, so as to form a first inclined surface 210. The second gate insulating layer 40 covers the first inclined surface 210. A first acute angle **a** is formed between the first inclined surface 210 and a plane where the active layer 10 is located. The first gate 30 has a second inclined surface 301 at the same side as the first inclined surface 210. A second acute angle **b** is formed between the second inclined surface 301 and the plane where the active layer 10 is located. A difference between the first acute angle **a** and the second acute angle **b** is less than or equal to 20 degrees. In the embodiments of the disclosure, the difference between the first acute angle **a** and the second acute angle **b** is limited in the above range, avoiding significant fluctuations and changes in morphology of the second gate insulating layer 40 at the position covering the first inclined surface 210 and the second inclined surface 301, improving the coverage uniformity and yield of the second gate insulating layer 40, and reducing the fracture risk of the second gate insulating layer 40 and the interlayer dielectric layer 60 due to the gradient of the inclined surfaces being too large.

In some embodiments, the first acute angle **a** is greater than the second acute angle **b.**

In some embodiments, the second gate insulating layer 40 includes a third sub-portion 41 disposed between the first gate 30 and the second gate 50, and a fourth sub-portion 42 connected to the third sub-portion 41, and a thickness of the third sub-portion 41 is less than or equal to a thickness of the fourth sub-portion 42. In some embodiments, as illustrated in FIG. 1, the thickness of the third sub-portion 41 can be equal to the thickness of the fourth sub-portion 42.

By setting the thickness of the second sub-portion 22 in the first gate insulating layer 20 less than the thickness of the first sub-portion 21, the embodiments of the disclosure enhance the ability of the display panel to supply hydrogen for the active layer 10. Therefore, on the basis of ensuring the requirement for supplying hydrogen, the thickness of the second gate insulating layer 40 can be reduced, that is, both of the thickness of the third sub-portion 41 and the thickness of the fourth sub-portion 42 can be reduced. Moreover, since the second insulating layer 40 is disposed on the first doping portion 12 and the second doping portion 13, the embodiments of the disclosure can reduce the dosage of boron for doping the first doping portion 12 and the second doping portion 13 and the energy required for the doping process. For example, the dosage of dopants and energy required for the doping can be reduced during an ion bombardment process.

In some embodiments, the driving circuit in the display panel further includes a storage capacitor, which includes the first gate 30 and the second gate 50 disposed opposite to each other. For example, the first gate 30 and the second gate 50 can be disposed opposite to each other in the thickness direction of the display panel. Moreover, when the thickness of the third sub-portion 41 is less than the thickness of the fourth sub-portion 42, a distance between the first gate 30 and the second gate 50 can be reduced, effectively increasing the capacitance of the storage capacitor consisting of the first gate 30 and the second gate 50, improving the performance of the driving circuit, and improving the display effect of the display panel.

In some embodiments, the thickness of the second gate insulating layer 40 is greater than or equal to 50 nm and less than 130 nm, for example, 50 nm, 60 nm, 70 nm, 80 nm, 90 nm, 100 nm, 110 nm, or 120 nm. That is, both of the thickness of the third sub-portion 41 and the thickness of the fourth sub-portion 42 can be greater than or equal to 50 nm and less than 130 nm. It has been verified that when the thickness of the second gate insulating layer 40 is thinner, the capacitance of the storage capacitor can be increased by 2.6 times. For example, when the thickness of the second gate insulating layer 40 is 50 nm, the capacitance of the storage capacitor can be increased by 2.6 times.

In view of foregoing, in some embodiments of the disclosure, by setting the first gate insulating layer 20 having different thicknesses, specifically, by setting the thickness of the first sub-portion 21 corresponding to the first gate 30 greater than the thickness of the second sub-portion 22 not corresponding to the first gate 30, on the basis of ensuring the insulation between the first gate 30 and the active layer 10, it can be achieved that hydrogen in the second gate insulating layer 40 can more easily diffuse into the active layer 10 through the second sub-portion 22, which improves the ability of the display panel to supply hydrogen for the active layer 10 without increasing the thickness of the second gate insulating layer 40 between the first gate 30 and the second gate 50. Moreover, by setting a smaller thickness of the second gate insulating layer 40 between the first gate 30 and the second gate 50, the capacitance of the storage capacitor consisting of the first gate 30 and the second gate 50 can be effectively increased. Based on the above, the embodiments of the disclosure effectively increase the capacitance of the storage capacitor in the display panel while ensuring the ability of the display panel to supply hydrogen for the active layer 10.

As illustrated in FIG. 2, some embodiments of the disclosure provide a display panel, which differs from the display panel shown in FIG. 1 in that the second gate insulating layer 40 has different thicknesses.

Specifically, the thickness of the third sub-portion 41 is less than the thickness of the fourth sub-portion 42, so as to increase the capacitance of the storage capacitor consisting of the first gate 30 and the second gate 50, and ensure the ability of the display panel to supply hydrogen for the active layer 10.

In some embodiments, the thickness of the third sub-portion 41 is greater than or equal to 50 nm and less than 130 nm, for example, 50 nm, 60 nm, 70 nm, 80 nm, 90 nm, 100 nm, 110 nm, or 120 nm; and the thickness of the fourth sub-portion 42 is greater than or equal to 130 nm.

In some embodiments, an orthographic projection of the first gate 30 on the first gate insulating layer 20 does not overlap with an orthographic projection of the fourth sub-portion 42 on the first gate insulating layer 20, and an orthographic projection of the second gate 50 on the first gate insulating layer 20 does not overlap with the orthographic projection of the fourth sub-portion 42 on the first gate insulating layer 20.

In some embodiments, the third sub-portion 41 is disposed on a side of the first sub-portion 21 away from the active layer 10, the fourth sub-portion 42 is disposed on a side of the second sub-portion 22 away from the active layer 10, and a surface of the third sub-portion 41 away from the active layer 10 is flush with a surface of the fourth sub-portion 42 away from the active layer 10. In the first gate insulating layer 20 and the second gate insulating layer 40 provided in some embodiments, both of the thickness of the first sub-portion 21 and the thickness of the fourth sub-portion 42 are larger, and both of the thickness of the second sub-portion 22 and the thickness of the third sub-portion 41 are smaller. Therefore, by setting the surface of the second gate insulating layer 40 away from the first gate insulating layer 20 being a flat surface (a surface consisting of the surface of the third sub-portion 41 and the surface of the fourth sub-portion 42 away from the active layer 10), the embodiments of the disclosure improve the flatness of the surface of the second gate insulating layer 40 and yield of subsequent film layers.

It can be understood that there may be a slight step difference at the surface of the second gate insulating layer 40 away from the first gate insulating layer 20. In some embodiments of the disclosure, when the step difference at the surface of the second gate insulating layer 40 away from the first gate insulating layer 20 is less than or equal to 20 nm, the surface of the second gate insulating layer 40 away from the first gate insulating layer 20 can be considered as a flat surface.

In view of foregoing, in some embodiments of the disclosure, by setting the first gate insulating layer 20 having different thicknesses, specifically, by setting the thickness of the first sub-portion 21 corresponding to the first gate 30 greater than the thickness of the second sub-portion 22 not corresponding to the first gate 30, on the basis of ensuring the insulation between the first gate 30 and the active layer 10, it can be achieved that hydrogen in the second gate insulating layer 40 can more easily diffuse into the active layer 10 through the second sub-portion 22, which improves the ability of the display panel to supply hydrogen for the active layer 10. Moreover, by setting the second gate insulating layer 40 having different thicknesses, specifically, by setting the thickness of the third sub-portion 41 disposed between the first gate 30 and the second gate 50 less than the thickness of the fourth sub-portion 42 disposed above the second sub-portion 22, the embodiments of the disclosure further enhance the ability of the display panel to supply hydrogen for the active layer 10, and increase the capacitance of the storage capacitor in the display panel. Based on the above, on the basis of enhancing the ability of the display panel to supply hydrogen for the active layer 10, the capacitance of the storage capacitor can be effectively increased.

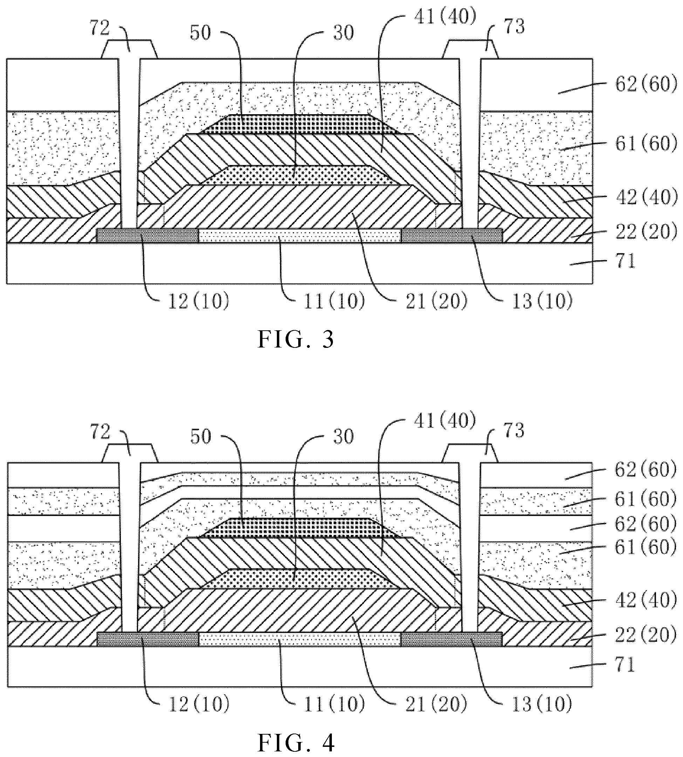

In some embodiments, as illustrated in FIG. 3, the interlayer dielectric layer 60 is disposed on a side of the second gate insulating layer 40 away from the first gate insulating layer 20, and covers the second gate 50.

In some embodiments, the interlayer dielectric layer 60 includes at least one first sub-layer 61 and at least one second sub-layer 62 disposed in stack. As illustrated in FIG. 3, taking the interlayer dielectric layer 60 including one first sub-layer 61 and one second sub-layer 62 as an example for description in the following.

A material of the first sub-layer 61 includes at least one of silicon nitride and silicon oxynitride, a material of the second sub-layer 62 includes silicon oxide, and the first sub-layer 61 is in contact with the second gate insulating layer 40. It can be understood that during the baking process for preparing the display panel, silicon nitride and silicon oxynitride can supply hydrogen for the active layer 10 disposed below them. Therefore, in the embodiments of the disclosure, the first sub-layer 61 made of silicon nitride and/or silicon oxynitride is in contact with the second gate insulating layer 40, which further enhances the ability of the display panel to supply hydrogen for the active layer 10.

In some embodiments, a thickness of the first sub-layer 61 being in contact with the second gate insulating layer 40 is greater than a thickness of the second sub-layer 62, so as to increase a thickness of silicon nitride layers stacked above the active layer 10, further enhance the ability of the display panel to supply hydrogen for the active layer 10, effectively reduce the sub-threshold swing of the thin film transistor, improve the mobility of the thin film transistor, and enhance the performance of the thin film transistor.

In view of foregoing, in some embodiments of the disclosure, by setting the first gate insulating layer 20 having different thicknesses, specifically, by setting the thickness of the first sub-portion 21 corresponding to the first gate 30 greater than the thickness of the second sub-portion 22 not corresponding to the first gate 30, on the basis of ensuring the insulation between the first gate 30 and the active layer 10, it can be achieved that hydrogen in the second gate insulating layer 40 can more easily diffuse into the active layer 10 through the second sub-portion 22, which improves the ability of the display panel to supply hydrogen for the active layer 10. Moreover, the embodiments of disclosure further design the distribution of sub-layers in the interlayer dielectric layer 60, so that the first sub-layer 61 of the interlayer dielectric layer 60 made of silicon nitride and/or silicon oxynitride is in contact with the second gate insulating layer 40, thereby enhancing the ability of the display panel to supply hydrogen for the active layer 10. In addition, by setting the thickness of the first sub-layer 61 being in contact with the second gate insulating layer 40 greater than the thickness of the second sub-layer 62, the embodiments increase the thickness of silicon nitride layers stacked above the active layer 10, further enhance the ability of the display panel to supply hydrogen for the active layer 10, effectively reduce the sub-threshold swing of the thin film transistor, improve the mobility of the thin film transistor, and enhance the performance of the thin film transistor.

As illustrated in FIG. 4, some embodiments of the disclosure provide a display panel, which differs from the display panel shown in FIG. 3 in that the interlayer dielectric layer 60 includes a plurality of first sub-layers 61 and a plurality of second sub-layers 62 alternately arranged in stack. FIG. 4 takes the interlayer dielectric layer 60 including two first sub-layers 61 and two second sub-layers 62 alternately arranged in stack as an example for illustration.

In the embodiments as illustrated in FIG. 4, a thickness of one of the two first sub-layers 61 being in contact with the second gate insulating layer 40 is greater than a thickness of another one of the two first sub-layers 61, and greater than a thickness of corresponding one of the two second sub-layers 62, so as to increase a thickness of silicon nitride layers stacked above the active layer 10, further enhance the ability of the display panel to supply hydrogen for the active layer 10, effectively reduce the sub-threshold swing of the thin film transistor, improve the mobility of the thin film transistor, and enhance the performance of the thin film transistor.

In view of foregoing, in some embodiments of the disclosure, by setting the first gate insulating layer 20 having different thicknesses, specifically, by setting the thickness of the first sub-portion 21 corresponding to the first gate 30 greater than the thickness of the second sub-portion 22 not corresponding to the first gate 30, on the basis of ensuring the insulation between the first gate 30 and the active layer 10, it can be achieved that hydrogen in the second gate insulating layer 40 can more easily diffuse into the active layer 10 through the second sub-portion 22, which improves the ability of the display panel to supply hydrogen for the active layer 10. Moreover, the embodiments of disclosure further design the distribution of sub-layers in the interlayer dielectric layer 60, so that the first sub-layer 61 of the interlayer dielectric layer 60 made of silicon nitride and/or silicon oxynitride is in contact with the second gate insulating layer 40, thereby enhancing the ability of the display panel to supply hydrogen for the active layer 10. In addition, by setting the thickness of one of the two first sub-layers 61 being in contact with the second gate insulating layer 40 greater than the thickness of corresponding one of the two second sub-layers 62, the embodiments increase the thickness of silicon nitride layers stacked above the active layer 10, further enhance the ability of the display panel to supply hydrogen for the active layer 10, effectively reduce the sub-threshold swing of the thin film transistor, improve the mobility of the thin film transistor, and enhance the performance of the thin film transistor.

In some embodiments, the display panel further includes a substrate 74 disposed at a side of the buffer layer 71 away from the active layer 10.

In some embodiments, the substrate 74 is a flexible substrate, for example, a material of the substrate 74 may include polyimide. Alternatively, the substrate 74 is a rigid substrate, such as a glass substrate.

In some embodiments, the display panel is a liquid crystal display panel. The display panel further includes a plurality of pixel electrodes, a plurality of common electrodes, a liquid crystal layer, a color film substrate, and other structures disposed on a side of the interlayer dielectric layer 60 away from the second gate insulating layer 40.

In some embodiments, the display panel is an organic light-emitting diode display panel. The display panel further includes an anode, an organic light emitting layer, a cathode, an encapsulation layer, a touch layer, and other structures disposed on a side of the interlayer dielectric layer 60 away from the second gate insulating layer 40.

Some embodiments of the disclosure further provide a display device including the display panel as described in any one of the above-mentioned embodiments.

In some embodiments, the display device includes a liquid crystal display device or an organic light-emitting diode display device.

It can be understood that since the display device includes the display panel as described in any one of the above-mentioned embodiments, the display device has the same beneficial effects as the display panel described in any one of the above-mentioned embodiments, which will not be repeated here.

In the above embodiments, the description of each embodiment has its own emphasis. For the parts that are not detailed in one embodiment, please refer to the relevant descriptions of other embodiments.

The above provides a detailed introduction to the display panel and the display device provided in the embodiments of the disclosure. Specific embodiments are applied in this context to explain the principles and implementation methods of the disclosure. The explanation of the above-mentioned embodiments is only used to help understand the technical solutions and core ideas of the disclosure. For ordinary skilled in the art, there may be changes in the specific implementation methods and application scopes based on the ideas of the disclosure. Therefore, the contents of the disclosure should not be understood as limitations on the disclosure.

## Claims

1. A display panel **characterized in that** the display panel comprises:
an active layer;
a first gate insulating layer covering the active layer;
a first gate disposed on a side of the first gate insulating layer away from the active layer; and
a second gate insulating layer disposed on a side of the first gate insulating layer away from the active layer and covering the first gate, wherein the second gate insulating layer contains hydrogen element;
wherein the first gate insulating layer comprises a first sub-portion disposed between the active layer and the first gate, and a second sub-portion connected to the first sub-portion, wherein a thickness of the first sub-portion is greater than a thickness of the second sub-portion.

2. The display panel of claim 1, wherein an orthographic projection of the first gate on the second gate insulating layer does not overlap with an orthographic projection of the second sub-portion on the second gate insulating layer.

3. The display panel of claim 1, wherein the active layer comprises a channel portion, a first doping portion, and a second doping portion, and the first doping portion and the second doping portion are connected to opposite two sides of the channel portion, respectively; and
the first gate is disposed on a side of the first gate insulating layer away from the channel portion, and the first sub-portion is disposed between the first gate and the channel portion.

4. The display panel of claim 3, wherein an orthographic projection of the second sub-portion on the second gate insulating layer partially overlaps with an orthographic projection of the first doping portion and an orthographic projection of the second doping portion on the second gate insulating layer, and the orthographic projection of the second sub-portion on the second gate insulating layer does not overlap with an orthographic projection of the channel portion on the second gate insulating layer.

5. The display panel of claim 1, wherein a thickness of an end of the first sub-portion gradually decreases in a direction close to the second sub-portion to form a first inclined surface, the second gate insulating layer covers the first inclined surface, and a first acute angle is formed between the first inclined plane and a plane where the active layer is located; and
the first gate has a second inclined surface at the same side as the first inclined surface, and a second acute angle is formed between the second inclined surface and the plane where the active layer is located;
wherein a difference between the first acute angle and the second acute angle is less than or equal to 20 degrees.

6. The display panel of claim 1, wherein a difference between the thickness of the first sub-portion and the thickness of the second sub-portion is less than or equal to 80 nm;
optionally, the thickness of the second sub-portion is greater than or equal to 50 nm and less than 130 nm.

7. The display panel of claim 1, further comprising a second gate disposed on a side of the second gate insulating layer away from the first gate, wherein the second gate insulating layer comprises a third sub-portion disposed between the first gate and the second gate, and a fourth sub-portion connected to the third sub-portion, wherein a thickness of the third sub-portion is less than or equal to a thickness of the fourth sub-portion.

8. The display panel of claim 7, wherein the third sub-portion corresponds to the first sub-portion and is disposed on a side of the first gate away from the active layer, the fourth sub-portion is disposed on a side of the second sub-portion away from the active layer, and the thickness of the third sub-portion is less than the thickness of the fourth sub-portion.

9. The display panel of claim 8, wherein a surface of the third sub-portion away from the active layer is flush with a surface of the fourth sub-portion away from the active layer.

10. The display panel of claim 7, wherein the thickness of the third sub-portion is greater than or equal to 50 nm and less than 130 nm.

11. The display panel of claim 7, further comprising a driving circuit, wherein the driving circuit comprises a storage capacitor, and the storage capacitor comprises the first gate and the second gate disposed opposite to each other.

12. The display panel of claim 1, further comprising an interlayer dielectric layer, wherein the interlayer dielectric layer is disposed on a side of the second gate insulating layer away from the first gate insulating layer, and the interlayer dielectric layer comprises at least one first sub-layer and at least one second sub-layer disposed in stack; and
wherein the first sub-layer is in contact with the second gate insulating layer; and a material of the first sub-layer comprises at least one of silicon nitride and silicon oxynitride, and a material of the second sub-layer comprises silicon oxide.

13. The display panel of claim 12, wherein a thickness of the first sub-layer is greater than a thickness of the second sub-layer;
optionally, the interlayer dielectric layer comprises a plurality of first sub-layers, wherein a thickness of one of the plurality of first sub-layers being in contact with the second gate insulating layer is greater than a thickness of one of the plurality of first sub-layers other than the one of the plurality of first sub-layers being in contact with the second gate insulating layer, and greater than a thickness of the second sub-layer.

14. The display panel of any one of claims 1 to 13, wherein a material of the active layer comprises low-temperature polycrystalline silicon, and a material of the second gate insulating layer comprises at least one of silicon nitride and silicon oxynitride.

15. A display device, **characterized in that** the display device comprises the display panel as claimed in any one of claims 1 to 14.
